# EUROPEAN PATENT APPLICATION

(11) **EP 3 343 614 A2**
(43) Date of publication of application: **04.07.2018**
(21) Application number: 17210357.4
(22) Date of filing: 22.12.2017
(51) Int. Cl.: H01L 27/02, H01L 27/118, H01L 29/66, H01L 29/78

(54) **STANDARD CELL FOR VERTICAL TRANSISTORS**

(30) Priority: 29.12.2016 EP 16207216
(71) Applicant: IMEC vzw, 3001 Leuven (BE); Vrije Universiteit Brussel, 1050 Brussel (BE)
(72) Inventor: RYCKAERT, Julien, 3001 Leuven (BE); HUYHN BAO, Trong, 3001 Leuven (BE)
(74) Representative: AWA Sweden AB

(57) **Abstract**

A standard cell semiconductor device (1) is disclosed, comprising a substrate (110), a unit cell (10) having a first transistor (11) and a second transistor (12), a gate layer (120) common to the first and second transistor, and a set of routing tracks (T1, T2, T3) for contacting the first and second transistor. Each one of the first and second transistors is formed of a stack of layers arranged between at least some of the routing tracks and the substrate, wherein each stack comprises a bottom terminal (130) arranged on the substrate, a channel (140) arranged on the bottom terminal and a top terminal (150) arranged on the channel. The channel of the first transistor is an N-type channel and the channel of the second transistor is a P-type channel. Further, the routing tracks comprises a pair of power routing tracks (T1, T2) arranged on opposite sides of the unit cell and adapted to contact the top terminal of the first and second transistor, and a gate track (T3) arranged between the pair of routing tracks and adapted to contact the gate layer at a position beside the unit cell.

## Description

### Technical field

The present inventive concept relates to the field of semiconductor devices, and in particular to a standard cell semiconductor device comprising a first transistor and a second transistor having a vertical channels and a common gate.

### Background

In semiconductor fabrication, standard cell methodology typically involves designing integrated circuits having various functionality using standard components and interconnect structures. Standard cell methodology uses an abstraction wherein low level integrated syntheses is replaced by a more high-level aspect of design. A standard cell can be made up of a group of transistor structures, passive structures, and interconnect structures that make up e.g. logic functions, storage functions or the like.

As integrated circuits continue to becomes smaller and smaller and simultaneously comprise an increasing number of electronic components within a given area, there is a strive for reducing the size of the standard cell.

Vertical transistors, i.e., transistors in which the channel region is arranged such that the current in the conducting state flows mainly in a direction perpendicular to a main plane of extension of a substrate of the semiconductor device, have been implemented so as to reduce the footprint of the transistors.

However, even though such a technology may allow for a reduced standard cell area, there is still a need for improved methods and devices allowing for a further reduction of the cell size.

### Summary

In view of the above, an objective of the present inventive concept is to provide a standard cell semiconductor device having a reduced height and an improved overall routing performance. Additional and alternative objects may be understood from the following.

According to a first aspect of the present inventive concept, there is provided a standard cell semiconductor device comprising a substrate, a unit cell having a first transistor and a second transistor, a gate layer common to the first and second transistor, and a set of routing tracks for contacting the first and second transistor. Each one of the first and second transistors may be formed of a stack of layers arranged between at least some of the routing tracks and the substrate, and may comprise a bottom terminal arranged on the substrate, a channel arranged on the bottom terminal, and a top terminal arranged on the channel. The channel of the first transistor may be an N-type channel, whereas the channel of the second transistor may be a P-type channel. Each channel may extend in its length direction between the bottom terminal and the top terminal, and the gate layer may at least partly cover the N-type channel and the P-type channel. Further, the routing tracks may comprise a pair of power routing tracks arranged on opposite sides of the unit cell and adapted to contact the top terminal of the first and second transistor, and a gate track arranged between the pair of routing tracks and adapted to contact the gate layer at a position beside the unit cell.

According to a second aspect of the present inventive concept, there is provided a standard cell semiconductor device comprising a substrate, a row of unit cells, each one of the unit cells having a first transistor and a second transistor connected by a common gate layer, and a set of routing tracks for contacting the unit cells. Each one of the first and second transistors may be formed of a stack of layers arranged between the routing tracks and the substrate, and may comprise a bottom terminal arranged on the substrate, a channel arranged on the bottom terminal, and a top terminal arranged on the channel. The channel of each first transistor may be an N-type channel, and the channel of each second transistor may be a P-type channel. Each channel may extend in its length direction between the bottom terminal and the top terminal. Further, the gate layer of each unit cell may at least partly cover the N-type channel and the P-type channel. The routing tracks may comprise a pair of power routing tracks arranged on opposite sides of the row of unit cells and adapted to contact the top terminal of the first and second transistors, and a gate track arranged between the pair of routing tracks and adapted to contact the gate layer of each unit cell at a position between the unit cells of the row.

The inventive standard cell semiconductor device enables scaling of the device area and circuit density by employing the vertical dimension for orienting the transistor channels. Moreover, the common gate structure of the complementary transistor arrangement improves the area density of the unit cell, and by accessing the gate layer at a position beside the unit cell the standard cell area may be further reduced.

The height of the standard cell (seen in a direction orthogonal to the routing tracks and in the plane of the substrate) may be determined by the number of routing tracks required for contacting the device, and by the nominal pitch of the routing tracks (i.e., the sum of the width of each routing track and the separation between adjacent routing tracks). Thus, a reduction in standard cell height may be achieved e.g. by reducing the number of required tracks, or by reducing the separation between the tracks.

The present inventive concept is advantageous in that the unit cell(s) may be connected by a pair of power routing tracks running at the top and the bottom of the standard cell, and one or several gate tracks arranged to contact the gate layer at a position laterally beside the unit cell(s), thereby reducing the number or routing tracks required for contacting the transistors of the unit cell(s).

By "vertical transistor" is hereby meant a stack configuration or arrangement wherein the channel region of the transistor is arranged such that the current in the conducting state flows through the channel mainly in the vertical direction, i.e., perpendicular to a surface / main plane of extension of the substrate. Consequently, the source/drain regions may be arranged at different level above, or distance from, the substrate as viewed along the vertical direction.

Vertical transistors provide a process-related advantage in that such structures may be rationally and reliably manufactured, wherein each part of the stack may be selectively grown in an optimised process. Advantageously, the source/drain regions of the transistor may be formed of different materials to reduce leakage current and also boost the drive current through the transistor. Further, the channel length may be determined by the vertical thickness of the layer rather than the resolution of the patterning process used in e.g. horizontally oriented devices. The vertical transistor architecture is also advantageous in that no dummy gates are needed for separating unit cells from each other, which allows for a reduction in cell area.

By each transistor including a vertically extending channel, such as e.g. a nanostructure channel or wire channel, the transistors may be provided with gate electrodes (i.e., polarity gate electrodes and / or control gate electrodes) completely or at least partly enclosing or wrapping-around the channels. The gate electrodes may hence be referred to as gate-all around electrodes. The transistors may correspondingly be referred to as gate-all around transistors. The transistors, and hence the semiconductor device, may thus present desirable electrical characteristics in terms of device control and standby leakage.

The afore-mentioned transistors may be field-effect transistors (FETs), such as a metal-oxide-semiconductor FET (MOSFET). The transistors may be a p-type FET or an n-type FET depending on the type of channel used. The combined unit cell comprising an n-type transistor and a p-type transistor connected to a common gate structure may be referred to a a complementary transistor device or complementary metal-oxide-semiconductor (CMOS). The gate layer, or gate structure may act on channel to control the on/off behavior of the transistor.

The gate layer may be formed of a layer extending in a lateral direction along the substrate. The lateral orientation allows for the same gate layer to contact the channel of both transistors of the unit cell. Further, the gate layer may extend laterally beyond the channels of the unit cell, i.e., beside the unit cell, such that the gate layer may be contacted or accessed from a position beside the unit cell. In case the device comprises a row of unit cells the gate layer may extend to a side of each unit cell to allow the gate layer to be contacted between two adjacent or consecutive unit cells.

A "source/drain" of a transistor may refer to either a source region or a drain region of a transistor. Whether the region acts as a "source" or "drain" is as understood by the skilled person dependent on the type or polarity of transistor (i.e. n- or p-type of the channel). The source or drain regions may be contacted by from above (i.e., from a vertical side of the unit cell facing away from the substrate) or from below, such as e.g. from a buried interconnect extending in the substrate or at a position between the substrate and the unit cell. The power supplied to the transistors may be referred to as V_{DD} or V_{SS}.

The top terminals of the transistors, forming or contacting the source/drain regions, may be contacted by power routing tracks running at mutually opposing sides of the standard cell (as seen in a lateral direction). These opposing sides may also be referred to as the top and the bottom of the standard cell. Further, the gate layer may be contacted by a gate track from a position beside the unit cell, i.e., at a lateral side between the top and the bottom positions of the standard cell, rather than a position within the unit cell or between the first and the second transistor. This standard cell layout is surface efficient and reduces the risk that via structures and other interconnecting means block or shadow each other.

As used herein, the terminology "electrical (inter-)connection" between elements or elements being "electrically (inter-)connected" or "contacted" should be understood as presence of a galvanic connection between the elements. In other words, a conducting structure is arranged in physical contact with the elements wherein the elements are electrically connected. Conversely, two elements being electrically isolated from each other should be understood as absence of an electrical or galvanic connection between the elements.

By "routing track" is hereby meant a space or design feature that can be used for defining a position or width in a standard cell. Accordingly, a conductor, via or conducting line may be formed in the routing tracks.

By height of a routing track, the standard cell or other structure or feature is herein meant the extension or dimension in a vertical direction of the standard cell, i.e., a direction perpendicular to the routing tracks of the cell and parallel to the main extension plane of the substrate supporting the standard cell. In the context of the present application, the term height may be used interchangeably with the term width.

By the term "above" is hereby meant a relative position as viewed in a normal direction from the main surface of the substrate. The terminology "above" does hence not refer to an absolute orientation of layers or features but to a relative ordering thereof.

The gate layer and/or the top/bottom terminals may be formed by layers including one or more metallization levels and one or more dielectric layers. Each metallization level may include a metallization layer. Metallization layers of adjacent metallization levels may be separated by a dielectric layer. The metallization layer may include conducting patterns or paths electrically interconnecting transistors and unit cells to each other and/or to routing tracks and buried power rails. The interconnection portion may include conducting vias connecting metallization layer through a dielectric layer.

The first transistor and the second transistor of a unit cell may be arranged beside each other in a direction orthogonal the pair of routing tracks, i.e., such that they extend in a row between the top and bottom power routing track of the standard cell.

Alternatively, the first transistor of a unit cell may be arranged beside each other in a direction parallel to the pair of routing tracks, such that the unit cell is laterally rotated 90° compared to the above orientation.

The channel of at least one of the transistors may be formed of one or several nanowires extending between the top and bottom terminal. In one example, the first transistor may comprise a plurality of n-type channels, such as nanowires, arranged in a first row, whereas the second transistor may comprise a plurality of p-type channels, such as nanowires, arranged in second row. The first row and the second row may be aligned with each other such that they are parallel and preferably opposing each other. The first row and the second row may e.g. be oriented parallel to the power routing tracks, or orthogonal to the same.

The pair of power routing tracks and the gate track may form a three tracks standard cell. In such a configuration, the pair of routing tracks may be connected to the top terminals of the first and second transistor, whereas the bottom terminal may be accessed from below, preferably from buried power lines. The buried power lines may e.g. be arranged directly below the bottom terminals. Using buried power lines allows for a reduced height of the standard cell, as the number of routing tracks (connecting the device from above) may be reduced.

Alternatively, or additionally, a further gate track may be used for connecting one or several of the gate layers of the device. Such an architecture may be referred to as a four tracks standard cell.

In one example, the standard cell may be provided with two pairs of power routing tracks for contacting and/or interconnecting a first one and a second one of a plurality of unit cells. The two pairs of power routing tracks may be combined with a single gate track to form a five tracks standard cell, or with a pair or gate tracks to form a six tracks standard cell.

It is noted that the present inventive concept relates to all possible combinations of features recited in the claims. Further, it will be appreciated that the various embodiments described for the standard cell semiconductor device according to the first aspect are all combinable with embodiments described for the standard cell semiconductor device according to the second aspect. Further objectives of, features of, and advantages with the present inventive concept will become apparent when studying the following detailed disclosure, the drawings, and the appended claims. Those skilled in the art will realise that different features of the present invention can be combined to create embodiments other than those described in the following.

### Brief description of the drawings

The above, as well as additional objects, features and advantages of the present inventive concept, will be better understood through the following illustrative and non-limiting detailed description of preferred embodiments of the present inventive concept, with reference to the appended drawings.
Figure 1 shows a perspective view of a unit cell, comprising a first transistor and a second transistor with a common gate layer.
Figure 2 schematically illustrates a top view of a standard cell semiconductor device comprising a unit cell.
Figure 3 shows a top view of a standard cell semiconductor device comprising a row of unit cells.
Figure 4 is top view of another standard cell semiconductor device having a row of unit cells.

As illustrated in the figures, the sizes of the elements, features and other structures may be exaggerated or not depicted proportionally for illustrative purposes. Thus, the figures are provided to illustrate the general elements of the embodiments.

In the drawings, like reference numerals will be used for like elements unless stated otherwise.

### Detailed description

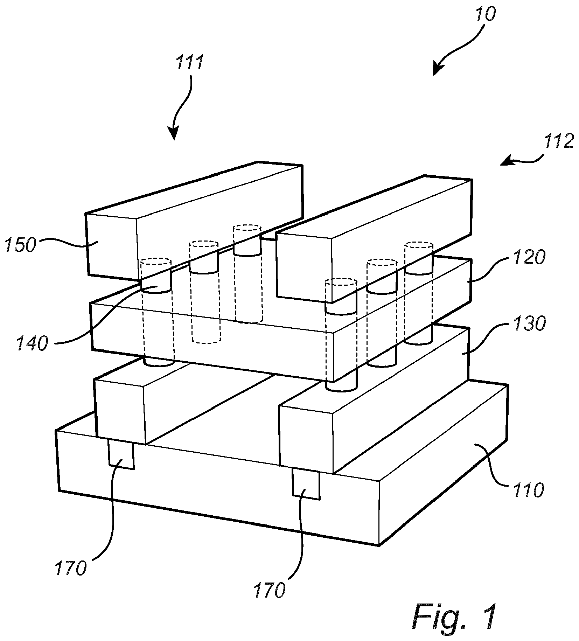

A unit cell 10 comprising a first vertical transistor 111 and a second vertical transistor 112 will now be described with reference to figure 1. Each of the transistors 111, 112 may be formed of a vertical stack formed on, or above, a substrate 110. The present figure schematically shows the portion of the substrate 110 on which the unit cell 10 is arranged. The substrate 110 may accordingly extend laterally / horizontally beyond the illustrated portion. The substrate 110 may for instance be a (bulk) silicon substrate, a silicon-on-insulator (SOI) substrate, a germanium-on-insulator (GeOI) substrate or a dielectric substrate.

The first transistor 111 may include a vertically extending channel 140, such as e.g. a nanowire 140, which may be of n-type. The channel 140 may include first and second source/drain (regions) connected to a respective top/bottom terminal or electrode 130, 150 arranged on opposite sides of the channel 140. The bottom electrode 130 may be separated from the substrate 110 by a dielectric (not shown). The bottom electrode 130 may hence be isolated from the substrate 110. The bottom electrodes 130 may also be arranged directly on a dielectric portion of the substrate 110, for instance a dielectric layer such or an oxide formed on the substrate 110.

The second transistor 112 may be similarly configured as the first transistor 111, but with a p-type channel 140 extending between the top/bottom electrodes 130, 150. Thus, the first and second transistor 111, 112 may form a complementary transistor pair or a CMOS structure.

The channels 140 may comprise one or several nanostructures, such as e.g. a row of three parallel nanowires 140 as indicated in the example of figure 1.

The unit cell 10 may further include a gate layer 120 forming a gate electrode 120 for the first transistor 111 and the second transistor 112. The gate layer 120 may be common for both transistors 111, 112, which thereby may be electrically connected to each other to form the complementary transistor pair. The gate electrode 120 may enclose the channel 140 at least along a longitudinal portion thereof, e.g. to form a gate-all-around transistor.

The gate layer 120 may include one or more metals (or alloys thereof), for instance Ti, W, T, Al. Further, a gate dielectric (not shown in the figure) may be arranged between the channel 140 and the gate layer 120. The gate dielectric may include a low-k dielectric such as an oxide, for instance a SiO2, and/or a high-k dielectric, for instance HfO2 or ZrO2.

The bottom electrode 130 may be connected to a buried power line 170, which e.g. may be arranged in the substrate 110 or between the substrate 110 and the transistor 111, 112 so as to connect the source/drain of the transistor to electrical power. The bottom electrode 130 and the power line 170 may be separated by an intermediate dielectric layer (not shown in figure 1), which may be provided with openings or contact structures at position where an electrical connection between the bottom electrode 130 and the power line 170 is desired. The contact structures may e.g. be formed by means of lithographic patterning of the intermediate dielectric.

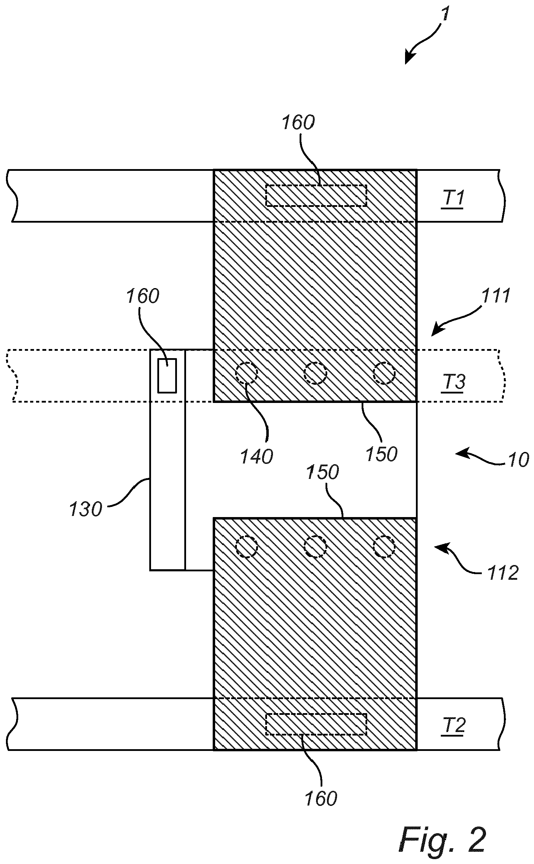

Figure 2 illustrates a standard cell semiconductor device 1 comprising a unit cell 10, which may be similarly configured as the unit cell 10 discussed above in connection with figure 1. The standard cell 1 may comprise a pair of (unidirectional) power routing tracks T1, T2 arranged at the top and the bottom of the standard cell such that the unit cell 10 may be arranged therebetween. The first transistor 111 and the second transistor 112 of the unit cell 10 may be arranged in a row, i.e., consecutively, between the top power routing track T1 and the bottom power routing track T2. As indicated in figure 2, the top electrode 150 of the first transistor 111 may be connected to the top power routing track T1 by means of an interconnect structure 160, such as an electrical via 160. Similarly, the top electrode 150 of the second transistor 112 may be connected to the bottom power routing track T2 by means of e.g. a via connection 160. The top power routing track T1 may e.g. connect the complementary transistor structure to V_{DD}, whereas the bottom power routing track T2 may connect the transistor structure to V_{SS}. The bottom electrode 130 of each transistor T1, T2 may be connected to a buried power line (not shown in figure 2).

Further, a gate track T3 may be provided between the pair of power routing tracks T1, T2 for contacting the common gate layer 130 of the unit cell 10. The position of the gate track T3 is merely indicated by dashed lines in the present figure. The distance between the tracks may be characterized in terms of metal-pitches (MP), which may be understood as the centre to centre distance between tracks having minimum width and minimum spacing. In the example shown the present figure, the distance between the tracks T1 and T3 may therefore be expressed as 1 x MP, whereas the distance between tracks T3 and T2 may be 2 x MP, resulting in a cell height of 3 x MP. Thus, the present standard cell may be referred to as a three track (3T) standard cell. It should be noted this standard cell may have a height corresponding to 4 routing tracks.

The common gate layer 130 may extend beyond the first and second transistors T1, T2 in a lateral direction, preferably to a side of the unit extending between the pair of power routing tracks T1, T2. This allows for the gate layer 130 to be contacted at a position beside the unit cell 10, i.e., at a position outside the transistors T1, T2 rather than between them. The gate track T3 may contact or access the gate layer by means of a via or interconnect structure 160.

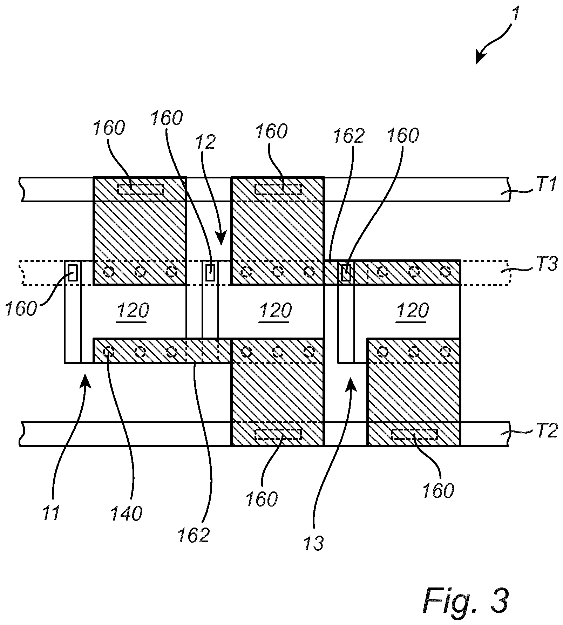

Figure 3 illustrates a standard cell semiconductor device 1 similarly configured as the device in figure 2, comprising a row of e.g. three unit cells 11, 12, 13. Each one of the unit cells 11, 12, 13 may be connected, indirectly or directly, to the top power routing track T1 and the bottom power routing track T2. In the specific example illustrated, the second unit cell 12 may be connected directly to the top power routing track T1 and the bottom power routing track T2 through the interconnects 160. Further, the first unit cell 11 may be connected directly to the top power routing track T1 and indirectly, via the second unit cell 12, to the bottom power routing track T2. Similarly, the third unit cell 13 may be directly connected to the bottom power routing track T2 and indirectly, via the second unit cell 12, to the top power routing track T1. The distance between the tracks T1 and T3 may be 1 x MP and the distance between T3 and T2 2 x MP, giving a total cell height of 3 x MP. Hence, the cell is a 3T cell (having a height corresponding to 4 routing tracks).

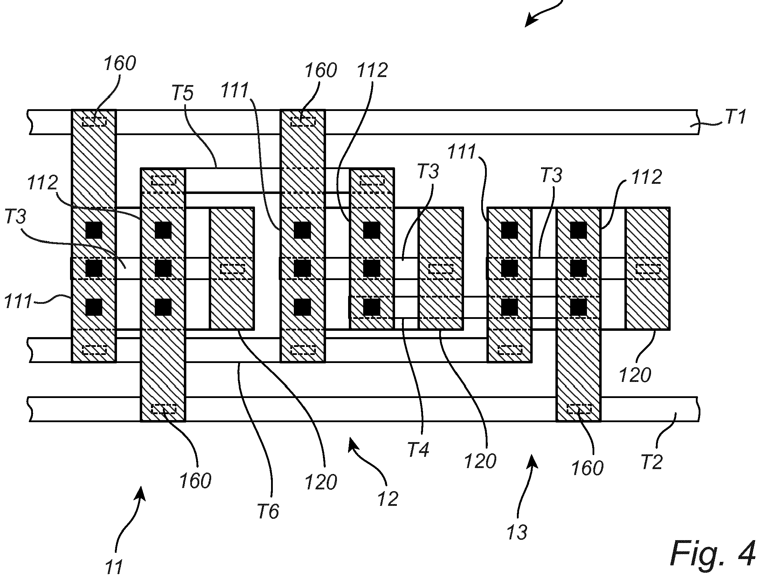

Figure 4 shows a standard cell semiconductor device 1 comprising a plurality of unit cells 11, 12, 13 which may be similarly configured as the unit cells described in connection with figures 1 to 3. However, the unit cells according to the present example may be oriented such that the first and second transistor 111, 112 of each unit cell 11, 12, 13 may be oriented beside each other in a direction parallel to the routing tracks T1-T6 of the standard cell. This allows for the metal layers, i.e. the top/bottom electrodes and the gate contacts, to be oriented in a regular, unidirectional manner which is easier to print.

The top electrode of the first transistor 111 of the first, second and third unit cells 11, 12, 13 may be interconnected by an interconnecting track T6, and directly or indirectly supplied with e.g. V_{DD} from the top power routing track T1 through interconnect 160. Further, the top electrode of the second transistor of the first and the second unit cells 11, 12 may be interconnected to each other by interconnecting track T5, and supplied with e.g. V_{SS} from the bottom power routing track an interconnecting structure 160. The gate electrodes, or gate layer 120, of the unit cells 11, 12, 13 may be accessed at positions beside the unit cells, i.e., at positions between adjacent unit cells of the device 1. The positions of the gate layer contacting points may be defined by a first and a second gate track T3, T4. As indicated in the present figure, the distance between tracks T1 and T5 is 1 x MP, between T5 and T3 2 x MP, between T3 and T6 2 x MP, and between T6 and T2 1 x MP, giving a total cell height of 6 x MP. Thus, the present standard cell may be referred to as a six track (6T) standard cell, requiring six routing tracks for connecting the transistors of the device and having a height corresponding to seven routing tracks.

In the above, the inventive concept has mainly been described with reference to a limited number of examples. However, as is readily appreciated by a person skilled in the art, other examples than the ones disclosed above are equally possible within the scope of the inventive concept as defined by the appended claims. Variations to the disclosed embodiments may be understood and effected by the skilled person in practicing the inventive concept, from a study of the drawings, the disclosure and the appended claims.

## Claims

1. A standard cell semiconductor device (1), comprising:
a substrate (110);
a unit cell (10) having a first transistor (11) and a second transistor (12);
a gate layer (120) common to the first and second transistor; and
a set of routing tracks (T1, T2, T3) for contacting the first and second transistor; wherein:
each one of the first and second transistors is formed of a stack of layers arranged between at least some of the routing tracks and the substrate, each stack comprising:
a bottom terminal (130) arranged on the substrate;
a channel (140) arranged on the bottom terminal; and
a top terminal (150) arranged on the channel;
the channel of the first transistor is an N-type channel and the channel of the second transistor is a P-type channel, each channel extending in its length direction between the bottom terminal and the top terminal;
the gate layer at least partly covers the N-type channel and the P-type channel; and wherein
the routing tracks comprises:
a pair of power routing tracks (T1, T2) arranged on opposite sides of the unit cell and adapted to contact the top terminal of the first and second transistor; and
a gate track (T3) arranged between the pair of routing tracks and adapted to contact the gate layer at a position beside the unit cell.

2. A standard cell semiconductor device (1), comprising
a substrate (110);
a row of unit cells (11, 12, 13), each one of the unit cells having a first transistor (111) and a second transistor (112) connected by a common gate layer (120);
a set of routing tracks (T1, T2, T3) for contacting the unit cells; wherein:
each one of the first and second transistors is formed of a stack of layers arranged between the routing tracks and the substrate, each stack comprising:
a bottom terminal (130) arranged on the substrate;
a channel (140) arranged on the bottom terminal; and
a top terminal (150) arranged on the channel;
the channel of each first transistor is an N-type channel and the channel of each second transistor is a P-type channel, each channel extending in its length direction between the bottom terminal and the top terminal;
the gate layer of each unit cell at least partly covers the N-type channel and the P-type channel; and wherein
the routing tracks comprises:
a pair of power routing tracks (T1, T2) arranged on opposite sides of the row of unit cells and adapted to contact the top terminal of the first and second transistors; and
a gate track (T3) arranged between the pair of routing tracks and adapted to contact the gate layer of each unit cell at a position between the unit cells of the row.

3. The standard cell semiconductor device according to claim 1 or 2, wherein the first transistor and the second transistor are arranged beside each other in a direction orthogonal the pair of routing tracks.

4. The standard cell semiconductor device according to any one of the preceding claims, wherein the first transistor and the second transistor are arranged beside each other in a direction parallel to the pair of routing tracks.

5. The standard cell semiconductor device according to any one of the preceding claims:
the first transistor comprises a plurality of N-type channels arranged in a first row; and
the second transistor comprises a plurality of P-type channels arranged in second row;
wherein the first row and the second row are parallel and opposing each other.

6. The standard cell semiconductor device according to any one of the preceding claims, wherein the channel comprises a nanowire.

7. The standard cell semiconductor device according to any one of the preceding claims, wherein the pair of power routing tracks and the gate track form a three tracks, 3T, standard cell.

8. The standard cell semiconductor device according to any one of claims 1 to 6, comprising a pair of gate tracks (T3, T4) which together with the pair of power routing tracks form a four tracks, 4T, standard cell.

9. The standard cell semiconductor device according to any one of claims 1 to 6, comprising two pairs of power routing tracks (T1, T6; T2, T5) adapted to contact the top terminal of the first and second transistors of a respective unit cell, and a pair of gate tracks, which together with the two pairs of power routing tracks form a six tracks, 6T, standard cell.

10. The standard cell semiconductor device according to any one of the preceding claims, further comprising a buried power rail (170) adapted to contact the bottom terminal.

11. The standard cell semiconductor device according to any one of the preceding claims, wherein the first transistor and the second transistor are gate-all-around transistors.
